Europäisches Patentamt

**European Patent Office** (11) Numéro de publication: **0 032 647**

**Office européen des brevets** **A1**

## (12) DEMANDE DE BREVET EUROPEEN

(21) Numéro de dépôt: **80401851.3**

(22) Date de dépôt: **23.12.80**

(51) Int. Cl.³: **F 02 P 17/00,** G 01 R 19/155, G 01 R 15/06

(30) Priorité: **17.01.80 FR 8000977**

(43) Date de publication de la demande: **29.07.81 Bulletin 81/30**

(84) Etats contractants désignés: **DE GB IT SE**

(71) Demandeur: **REGIE NATIONALE DES USINES RENAULT, Boite postale 103 8-10 avenue Emile Zola, F-92109 Boulogne-Billancourt (FR)**

(72) Inventeur: **Lombard, Claude, 60, rue Corneille, F-78150 Le Chesnay (FR)**

(74) Mandataire: **Jacques, Max et al, RNUR - S. 0804 BP 103, F-92109 Boulogne Billancourt (FR)**

(54) **Capteur de synchronisme pour moteur à allumage commandé.**

(57) Capteur de la haute tension pulsée d'allumage du moteur sur moteur à combustion interne comportant deux condensateurs (9, 11, 12, 13) concentriques autour du conducteur de haute tension, les deux condensateurs constituant un diviseur de tension, dont la tension réduite est appliquée à un circuit intégrateur (14, 17, 18, 19) placé à proximité immédiate des condensateurs dans le capteur. L'armature la plus externe (12) des condensateurs sert de blindage contre les champs parasites.

Application à la détection de l'instant d'allumage et à la synchronisation de l'injection de carburant.

## Capteur de synchronisme pour moteur à allumage commandé

La présente invention due à la collaboration de M. Claude LOMBARD se rapporte à un capteur de haute tension pulsée et en particulier de la haute tension d'allumage d'un moteur à combustion interne.

En mesurant l'instant où cette tension est appliquée à l'une des bougies, par exemple celle correspondant au cylindre n° 1, ce capteur permet de connaître l'instant du cycle où se trouve le moteur, alors qu'une information prélevée par un capteur magnétique sur le vilebrequin laisserait subsister un doute entre la phase compression et la phase échappement. Le capteur de tension fournit une double information, présence de la haute tension d'une part et son calage dans le temps d'autre part.

Il trouve son utilisation en station diagnostic pour la vérification du fonctionnement du moteur, ou de manière permanente sur véhicule pour la synchronisation de l'injection du carburant ou encore pour le contrôle permanent du calage de l'allumage sur les moteurs sans distributeur mécanique de haute tension.

Les capteurs de l'art antérieur sont soit des transformateurs de courant blindés entourant le fil de bougie, soit des diviseurs de tension dérivés directement de l'instrumentation électronique et peu adaptés au fonctionnement sur automobile.

D'une manière générale ces capteurs sont soit encombrants et coûteux, soit peu performants et en général influencés par les phénomènes induits lors des décharges dans les autres fils d'allumage. Les phénomènes parasites sont souvent presque du même ordre de grandeur que le phénomène utile d'où des erreurs rédhibitoires dans la détection du synchronisme.

La présente invention a pour objet un capteur de type capacitif, sensible aux variations de tension apparaissant sur le fil d'allumage, présentant la particularité de combiner un conducteur annulaire assurant son propre blindage contre les rayonnements parasites et un circuit électronique de détection de signal à proximité immédiate.
Cette forme de réalisation est peu sensible aux influences des autres
fils de bougie, même sans blindage général autour du circuit électronique, et conduit de ce fait à une amélioration très importante du
rapport signal/bruit donné par le capteur par rapport aux capteurs
usuels.

L'invention sera maintenant décrite en se référant aux figures annexées :

- la figure 1 est une vue d'ensemble montrant l'installation du capteur sur le moteur ;

- la figure 2 est le schéma d'un capteur selon l'invention avec condensateur annulaire dont le diélectrique est un matériau rigide,
  c'est par exemple une céramique ou un plastique relativement dur ;

- la figure 3 est une vue en coupe du condensateur selon la figure 2,
  enserrant le conducteur de bougie ;

- la figure 4 est une variante de réalisation selon la figure 2 avec
  circuit électronique réalisé dans la technologie dite hybride à
  film épais ou mince. Le support de ce circuit peut être quelconque,
  céramique, plastique, tôle émaillée, aluminium oxydé, etc.

- la figure 5 est une vue en coupe d'un capteur dans lequel le condensateur et le circuit électronique associé sont constitués à partir
  d'un film souple. Ce film souple et le conducteur de sortie du capteur sont maintenus en place par une double pince en plastique.

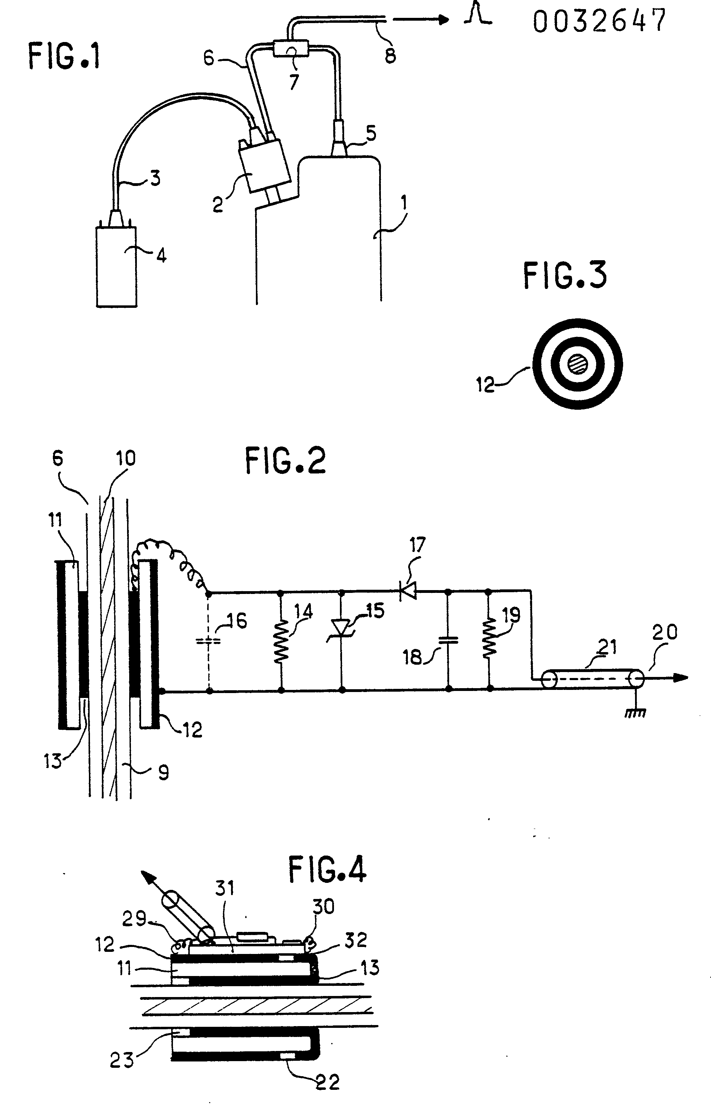

Sur la figure 1, installation d'ensemble du dispositif, le moteur 1 à
combustion interne porte un distributeur d'allumage 2 qui reçoit la
sortie haute tension 3 d'une bobine d'allumage 4 et adresse celle-ci
au moment du cycle voulu à la bougie 5 par un fil isolé 6 qui porte
le capteur 7 selon l'invention. La sortie 8 de ce capteur est reliée
à l'appareil utilisateur, c'est par exemple un calculateur électronique ou un oscillographe. Le distributeur 2 n'est pas indispensable au fonctionnement du capteur, et n'a été représenté que parce qu'il correspond au dispositif d'allumage le plus courant.

Sur la figure 2, nous retrouvons le fil haute tension 6 dont l'isolant est 9 et l'âme conductrice 10. Autour du fil 6 est disposée une bague rigide 11 en matériau diélectrique qui porte sur chacune de ses faces des métallisations 12 et 13. La métallisation 13 et l'âme 10 du fil 6 sont les armatures d'un premier condensateur dont le diélectrique est l'isolant 9. Les métallisations 12 et 13 forment entre-elles un deuxième condensateur dont l'isolant est 11. Les deux condensateurs étant en série, on peut prélever sur l'armature 13 une tension image de la haute tension sur l'âme 10 mais réduite dans le rapport des capacités des condensateurs dont les diélectriques sont 9 et 11, ces condensateurs constituant un diviseur de tension.

Sur la figure 3 on retrouve les différentes couches concentriques à partir de la métallisation extérieure 12.

Revenant à la figure 2, les armatures 12 et 13 sont reliées entre-elles par une résistance 14 et un élément limiteur de tension 15 qui peut, à titre d'exemple, être une diode Zener ultra-rapide.

Un condensateur 16 peut également être ajouté pour augmenter la valeur de capacité entre les armatures 12 et 13 si la tension recueillie est trop élevée. Une diode 17 relie l'armature 13 à un condensateur 18 ayant à ses bornes une résistance 19, la constante de temps de l'ensemble étant choisie suffisante pour intégrer les oscillations de haute tension, mais insuffisante pour maintenir le condensateur 18 chargé entre deux distributions d'allumage. L'autre extrémité du condensateur 18 et de la résistance 19 retourne à l'armature 12. La sortie du circuit électronique est 20, entourée d'une gaine de blindage 21.

L'armature extérieure 12 qui est à la masse du moteur ou du véhicule protège l'armature intérieure 13 des tensions induites par les fils d'allumage autres que 6 et notamment 3.

Le fonctionnement du dispositif est très simple. A chaque impulsion de tension apparaissant sur l'armature 13, la diode 17 charge le condensateur 18. La tension apparaissant sur la sortie 20 est envoyée dans un circuit électronique de mise en forme, non représenté et dont la nature dépend de l'application envisagée. Tel qu'il est décrit, sans normalisateur, le signal issu du dispositif est exploitable visuellement sur un oscillographe.

La résistance 14 évite l'accumulation de charges aux bornes du condensateur dont les armatures sont 12 et 13 - tandis que le limiteur de tension 15 ultra-rapide évite la détérioration des éléments électroniques en cas de fuite de haute tension sous l'influence de l'humidité par exemple qui peut provoquer des effluves.

La figure 4 est très voisine de la figure 2 mais la métallisation intérieure 13 a été étendue jusqu'à l'extérieur en 32 pour permettre le raccordement facile en 29 et en 30 d'un circuit hybride 31 à couches minces ou épaisses qui peut d'ailleurs être directement formé sur l'isolant 11. Des intervalles 22 et 23 sont prévus entre les métallisations.

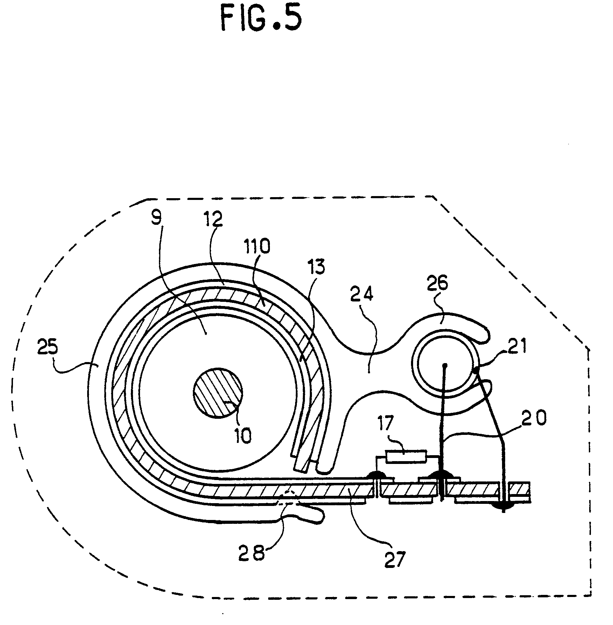

Dans la forme de réalisation décrite figure 5, le condensateur annulaire enserrant l'âme 10 et l'isolant 9 du fil d'allumage 6 n'est pas de révolution mais est constitué par l'enroulement autour de l'isolant 9 d'un film diélectrique souple 110 portant comme le diélectrique 11 sur chaque face des métallisations 12 et 13.

Une pince en plastique ou métallique 24 est constituée de deux parties 25 et 26. La partie 25 serre le film diélectrique autour de l'isolant 9 du fil 6 et laisse passer une longueur 27 de ce film. Cette partie 27 peut rester plane et porte les éléments électroniques et notamment la diode 17. Un crantage du film et un bossage de la pince en 28 peuvent coopérer pour maintenir le film en place au cours des opérations de montage.

La partie 26 de la pince 24 fixe le fil de sortie 20/21 du capteur, connecté par soudure ou rivetage sur les métallisations 12 et 13 de la partie 27.

0032647

Les ordres de grandeur des éléments utilisés sont donnés ci-dessous à titre indicatif, non limitatifs de la portée de l'invention, pour permettre une réalisation facile par l'homme de l'art :

- Capacité entre l'âme 10 et la métallisation 13 : 1 à 2 picofarads
- Capacité totale du condensateur extérieur y compris le condensateur 16 facultatif : 1.000 à 2.000 picofarads
- Condensateur 18 : 1.000 à 2.000 picofarads
- Résistance 14 : 2.000 ohms - Résistance 19 : 30.000 ohms.

Il est nécessaire de placer le circuit intégrateur à proximité immédiate du double condensateur annulaire car ceci évite de transporter sur le câble blindé de sortie du capteur les courants parasites à haute fréquence créés par l'étincelle à la bougie. Ces courants parasites iraient perturber le fonctionnement des systèmes électroniques connectés au capteur.

Avec des dispositifs usuels d'allumage ce capteur donne un signal de sortie de plusieurs volts, facile à exploiter.

La résistance de fuite 14 peut être supprimée si l'on remplace le diélectrique très bon isolant 11 ou 110 par un matériau relativement conducteur par exemple du plastique chargé en graphite. Ce matériau peut être métallisé relativement facilement.

On peut également incorporer le limiteur de tension 15 dans le "diélectrique" 11 en constituant celui-ci d'un oxyde semi-conducteur, à base de zinc par exemple.

On peut encore sans sortir du cadre de l'invention disposer une troisième couche concentrique de condensateur autour de la métallisation 12 en rendant annulaire le condensateur 18. Cependant les besoins du blindage peuvent amener la nécessité d'une armature supplémentaire reliée à 12 pour jouer le rôle d'écran. De ce fait, cette forme de réalisation, bien que tentante risque de conduire à des difficultés de fabrication et à des rendements faibles.

On peut enfin modifier la figure 5 en ne conservant que la partie extérieure 27 du film souple avec ses métallisations pour supporter les éléments électroniques et reporter les métallisations 12 et 13 sur les faces intérieure et extérieure de la partie 25 de la pince 24.

Le matériau de la pince 25 peut alors être réalisé en matériau légèrement conducteur pour supprimer la résistance 14 et même le limiteur de tension 15. Cette forme de réalisation se rapproche des figures 2 et 4 en leur ajoutant la partie 26 de la pince 24 pour supporter le conducteur de sortie.

REVENDICATIONS

1. Capteur mesurant la haute tension sur un fil d'allumage d'un moteur à combustion interne comportant successivement de l'intérieur à l'extérieur du capteur, un premier conducteur (10) traversant le capteur, un isolant (9) autour de celui-ci qui sont les constituants normaux du fil haute tension, une première métallisation annulaire (13) et une deuxième métallisation annulaire (12) reliée à la masse du moteur ou du véhicule et à l'extérieur de cet ensemble un circuit électronique intégrateur constitué d'au moins un condensateur et deux résistances, caractérisé en ce qu'il comprend successivement de l'intérieur à l'extérieur du capteur : ladite première métallisation annulaire (13), à nouveau un isolant (11, 110), ladite deuxième métallisation (12) extérieure, l'ensemble de ces isolants et conducteurs constituant deux condensateurs concentriques et ledit circuit électronique intégrateur étant inclus dans le capteur et comprenant en outre une diode (17) reliée d'une part à la plus intérieure des métallisations (13) et d'autre part au condensateur (18) dont l'autre extrémité est reliée à la plus extérieure des métallisations (12).

2. Capteur selon la revendication 1, caractérisé en ce que le diélectrique (11) du condensateur le plus extérieur est une céramique, un plastique dur isolant, un plastique conducteur de l'électricité, un oxyde semi-conducteur à seuil de tension ou plusieurs de ces éléments à la fois.

3. Capteur selon la revendication 2, caractérisé en ce que la métallisation interne est prolongée vers l'extérieur et qu'un circuit électronique du type hybride est rapporté ou formé sur la céramique (11) et ses métallisations.

4. Capteur selon la revendication 1, caractérisé en ce que le condensateur le plus extérieur, est constitué par un film diélectrique enroulé et métallisé sur ses 2 faces, l'une de ses extrémités au moins n'étant pas enroulée et portant les éléments électroniques.

5. Capteur selon la revendication 4, caractérisé en ce qu'une pince élastique double (24) maintient d'une part le film diélectrique enroulé autour du conducteur (10) et de l'isolant (9) et d'autre part le câble de sortie (20 - 21) du circuit électronique.

6. Capteur selon la revendication 2, caractérisé en ce qu'une pince élastique double en plastique conducteur ou non porte sur les deux faces de la partie enserrant le conducteur haute tension une métallisation et constitue le "diélectrique" (11) du condensateur le plus extérieur, l'autre partie de la pince immobilisant le conducteur de sortie.

7. Capteur selon l'une quelconque des revendications 1 à 5, caractérisé en ce qu'il comprend aux bornes du condensateur le plus extérieur un limiteur de tension ultra-rapide du genre diode Zener ou oxyde semi-conducteur à seuil de tension.

8. Capteur selon l'une quelconque des revendications 1 à 6, caractérisé en ce qu'un surmoulage exécuté en matériau plastique immobilise et isole l'ensemble des constituants du capteur ledit surmoulage donnant aux fils entrant ou sortant du capteur soit la forme d'un T soit la forme d'un Y.

FIG.1

FIG.3

FIG.2

1/2          0032647

FIG.4

## FIG.5

Office européen
des brevets

**RAPPORT DE RECHERCHE EUROPEENNE**

003264 7

Numéro de la demande

EP 80 40 1851

| Catégorie | DOCUMENTS CONSIDERES COMME PERTINENTS | | CLASSEMENT DE LA DEMANDE (Int. Cl.³) |
|---|---|---|---|
| | Citation du document avec indication, en cas de besoin, des parties pertinentes | Revendication concernée | |
| | US - A - 4 052 665 (C. GRUENWALD)<br>* Colonne 2, ligne 64 - colonne 3, ligne 6; figure 7 *<br>--<br>US - A - 4 040 294 (Y. MATSUDA, I. KIMURA, A. SAGAWA et T. HIRA-MATSU)<br>* Abrégé; figure 1 *<br>-- | 1<br><br>1 | F 02 P 17/00<br>G 01 R 19/155<br>G 01 R 15/06 |
| A | FR - A - 2 192 612 (SIEMENS)<br>* Page 8, lignes 1-15; figure 1 *<br>---- | 1 | **DOMAINES TECHNIQUES RECHERCHES (Int. Cl.³)**<br>G 01 R 19/155<br>19/145<br>15/06<br>31/00<br>F 02 P 17/00 |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 18-02-1981 | GALLO |

OEB Form 1503.1  06.78